# EUROPÄISCHE PATENTANMELDUNG

(11) **EP 1 858 309 A1**
(43) Veröffentlichungstag der Anmeldung: **21.11.2007**
(21) Anmeldenummer: 06113931.7
(22) Anmeldetag: 15.05.2006
(51) Int. Cl.: H05K 5/02, G09F 3/02

(54) **Belüftungsanordnung und Verfahren zur Herstellung derselben sowie Druckausgleichs-Element-Aufbau**

(71) Anmelder: Schreiner Group GmbH & Co. KG, 85764 Oberschleissheim (DE)
(72) Erfinder: Wechselberger, Dietmar, 84144 Geisenhausen (DE); Buchholz, Ralf, 85256 Vierkirchen (DE)
(74) Vertreter: Kehl, Günther

(57) **Zusammenfassung**

Die Erfindung betrifft eine Belüftungsanordnung für ein Bauteil, das zumindest teilweise aus Kunststoff besteht, welche eine Membranfolie aufweist, die mit einer Verbindungsfolie verbunden ist, wobei die Verbindungsfolie mit einer Spritzgussmasse mindestens teilweise verschmolzen ist. Weiterhin betrifft die Erfindung ein Herstellungsverfahren sowie einen Druckausgleichs-Element-Aufbau zur Herstellung der Belüftungsanordnung.

## Beschreibung

Die Erfindung betrifft eine Belüftungsanordnung für Kunststoffgehäuse sowie ein Verfahren zur Herstellung eines derartigen Kunststoffgehäuses mit Belüftungsanordnung und einen Druckausgleichs-Element-Aufbau zu seiner Herstellung.

In der Regel werden elektronische Geräte zum Schutz vor äußeren Einflüssen in Gehäuse eingebaut, die meist aus Kunststoff hergestellt sind. Zum Ausgleich der durch Temperaturschwankungen entstehenden Druckdifferenzen innerhalb solcher Gehäuse werden üblicherweise Belüftungsmembranen verwendet, die auf der Gehäusewand über eine Belüftungsöffnung verklebt oder per Ultraschall verschweißt werden, um ein wasserdichtes, aber belüftetes Gehäuse bereitzustellen. Als besonders vorteilhaft hat sich eine Belüftungslösung herausgestellt, bei der Druckausgteichsmembranen in einen Etikettenbereich integriert sind. Dieser technische Ansatz, wie er beispielsweise in
EP 0862354 B1 beschrieben wird, verbindet die Funktion eines Typenschilds mit der Belüftung zum Druckausgleich. Weiterhin ist es mit Hilfe der Folien- und Selbstklebetechnologie auch möglich, eine schützende Abdeckung über dem Membranbereich aufzubringen, so dass die Belüftung über ein Kanalsystem zwischen dieser Abdeckung und der Membran erfolgt. Derartige Lösungen sind beispielsweise aus EP 1630769 A1 bekannt.

Neben aufgeklebten Druckausgleichs-Membranen kommen auch Bauteile zur Anwendung, die in die Belüftungsöffnung verbaut werden und in ihrem Innenbereich wiederum eine über Belüftungskanäle zugängliche Membrane aufweisen. Derartige Teile sind zum Beispiel in EP 0377067 A1 offenbart.

Diese beschriebenen Lösungsansätze bieten für zahlreiche Anwendung eine schnelle und unkomplizierte Belüftungslösung, sind jedoch für manche Anwendungen nicht geeignet. Bauteile kommen zum Beispiel überall dort nicht in Frage, wo keine Teile von einem Gehäuse abstehen oder über seinen Umriß ragen dürfen. Selbstklebende Lösungen liegen zwar plan auf dem Gehäuse auf, sind jedoch nur in einem bestimmten Temperaturspektrum anwendbar und können auch bei mechanischer Beanspruchung abgelöst werden. Ähnliches gilt für ultraschall-verschweißte Druckausgleichs-Elemente, wobei hier vor allem die Gefahr besteht, dass die Membran beim Aufschweißen angegriffen wird.

Der Erfindung liegt daher die Aufgabe zugrunde, eine mit einer Membran ausgestattete Belüftungsanordnung für ein Kunststoffgehäuse bereitzustellen, die die genannten Nachteile überwindet und sich insbesondere dadurch auszeichnet, dass sie oberflächenbündig mit dem Gehäuse liegt und vorzugsweise eine erhöhte Verbindungsfestigkeit zwischen Gehäuse und Membran im Vergleich zu Selbstklebelösungen aufweist.

Die Erfindung bedient sich hierzu der sogenannten Inmould-Labelling-Technologie, das heißt des Integrierens eines Etiketts in ein Spritzgussbauteil durch Hinterspritzen des Etiketts während des Herstellungsprozesses des Bauteils. Die Inmould-Technologie findet derzeit vor allem in der Konsum-Verpackungs-Industrie breite Anwendung, beispielsweise bei der Dekoration von Kunststoffbechern für Kühlprodukte.

Erforderlich für das erfolgreiche Hinterspritzen von Folien ist jedoch, dass mindestens die Unterseite der zu hinterspritzenden Folie aus einem Material besteht, das kompatibel zum Spritzgussmaterial ist, vorzugsweise aus demselben Material. Druckausgleichsmembranen hingegen verbinden sich nur äußerst schlecht mit allen derzeit gebräuchlichen Spritzgussmaterialien. So werden beispielsweise Bauteile mit Membranen so hergestellt, dass die Ränder der Membran mit dem Bauteil verklemmt werden und nicht verklebt oder hinterspritzt.

Die oben beschriebene Aufgabe wird daher auch nicht durch eine herkömmliche Druckausgleichsmembran gelöst, sondern durch eine derartige Membran, die an einer Folie befestigt ist, deren Unterseite wiederum im Material kompatibel zum Spritzgussmaterial ist. Dieser Aufbau wird gemäß der Erfindung im Inmould-Verfahren hinterspritzt, woraus eine erfindungsgemäße Belüftungsanordnung hervorgeht.

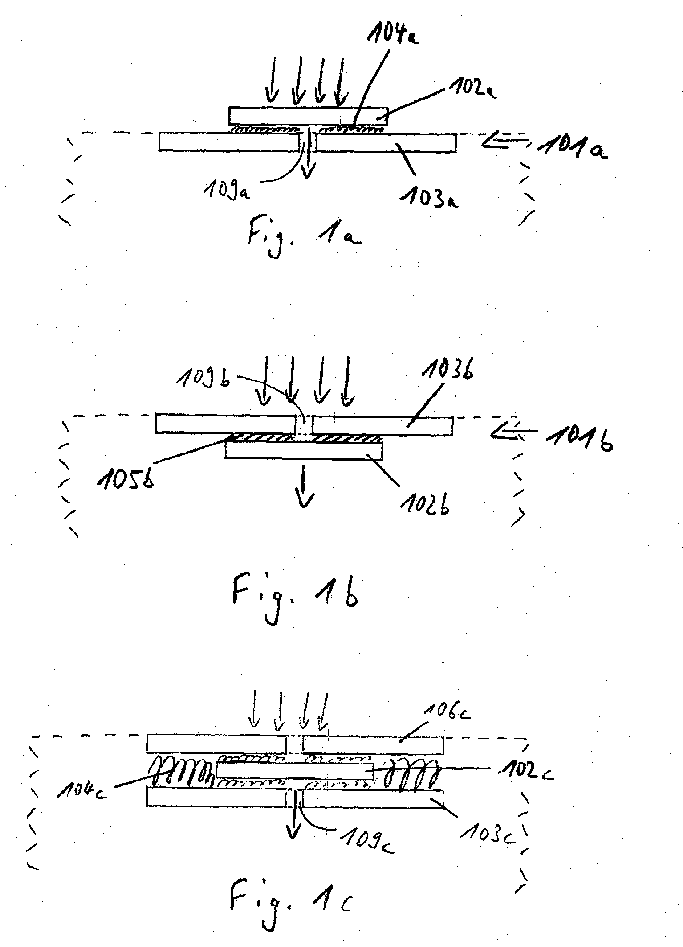

Im folgenden wird die Erfindung anhand der Figuren 1- detailliert dargestellt. Die Zeichnungen sind nicht maßstäblich zu verstehen; speziell Schichtdicken werden zur Verbesserung der Anschaulichkeit deutlich größer dargestellt. Es zeigen:
Figur 1a-c drei unterschiedliche Ausführungsformen eines erfindungsgemäßen Druckausgleichs-Element-Aufbaus zur Herstellung einer erfindungsgemäßen Belüftungsanordnung und
Figur 2 eine entsprechende Belüftungsanordnung,
   jeweils in Schnittdarstellung.

In Figur 1a ist ein erfindungsgemäßer Druckausgleichs-Element-Aufbau 101a dargestellt; bestehend aus einer Membranfolie 102a und einer Verbindungsfolie 103a. Die beiden Folien sind mittels eines Klebstoffs 104a, vorzugsweise eines thermisch stabilen Haftklebstoffs, miteinander verbunden. Die vier Pfeile oberhalb der Membranfolie und der Pfeil darunter deuten an, dass durch den Öffnungsbereich 109a, der in der Verbindungsfolie 103a gelassen wurde, Luft strömen kann. Die Richtung der Pfeile ist dabei nicht maßgeblich, da die Membran zum Zwecke des Druckausgleichs Luft oder andere Gase bzw. Gasgemische in beide Richtungen mit etwa der selben Durchflussrate durchlassen muß.

In Figur 1b ist ein analoger erfindungsgemäßer Druckausgleichs-Element-Aufbau 101b dargestellt (analog nummeriert), der sich im Prinzip vom Aufbau in Figur 1a durch zwei Veränderungen unterscheidet: Zum einen ist die Membranfolie 102b unterhalb der Verbindungsfolie 103b angeordnet und zum anderen wurde zur Herstellung einer Verbindung zwischen Membranfolie 102b und der Verbindungsfolie 103b eine Ultraschallschweißung verwendet, so dass die Verbindungsschicht 105b aus einer Schmelze der Verbindungsfolie 103b besteht. Diese beiden Abänderungen im Aufbau sind frei wählbare und nicht miteinander in Zusammenhang stehende mögliche Varianten des Aufbaus aus Figur 1a.

In Fig. 1c ist eine dritte bevorzugte Ausführungsform eines erfindungsgemäßen Druckausgleichs-Element-Aufbaus abgebildet. Sie kombiniert die beiden beschriebenen Lösungen aus Figuren 1a und 1b: Eine Membranfolie 102c ist mittels eines Klebstoffs 104c mit einer Verbindungsfolie 103c verbunden. Die Klebstoffschicht dient jedoch weiterhin auch dazu, eine Deckfolie 106c mit der Verbindungsfolie 103c und der Membranfolie 102c zu verbinden.

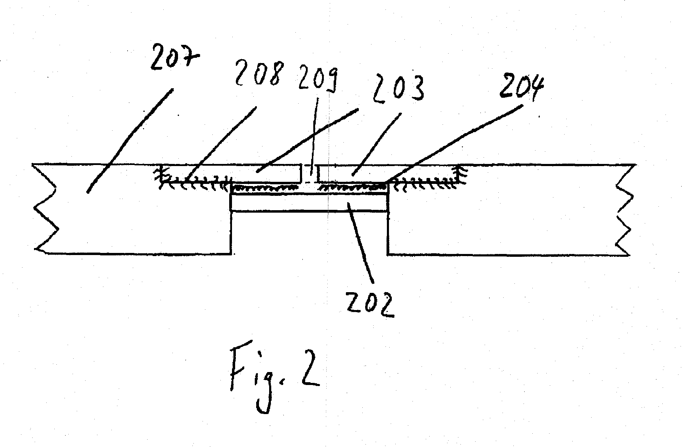

In Figur 2 ist eine erfindungsgemäße Belüftungsanordnung dargestellt. Sie besteht aus einem Aufbau wie anhand der Figuren 1a und 1b beschrieben, der mit Hilfe des Inmould-Verfahrens in ein Bauteil hinterspritzt ist. Die Membranfolie 202 ist mit einem Klebstoff 204 wiederum an einer Verbindungsfolie 203 befestigt, die in der Mitte eine Belüftungsöffnung aufweist. Durch Hinterspritzen der Verbindungsfolie 203 mit einer Spritzgussmasse entsteht ein Spritzgussteil 207, das in einem Übergangsbereich 208 (angedeutet durch geschwungene Durchbruchlinien) fest mit der Verbindungsfolie 203 verbunden (verschmolzen) ist. Im Bereich der Membranfolie 202 wurde durch die Geometrie des Spritzgußwerkzeugs eine Hinterspritzung der Membranfolie 202 vermieden. Je nach Anwendungsfall kann die Spritzgussmasse auch teilweise unterhalb der Membranfolie 202 hinterspritzt werden. Hierdurch ergibt sich zwar keine feste Verbindung, doch die Membranfolie wird zusätzlich zwischen der Spritzgussmasse und der Verbindungsfolie 203 fixiert. Über die Klebstoffverbindung 204 ist somit der dichte und bündige Verschluß des Spritzgussteils gewährleistet.

Abhängig von den Materialien für die beiden Folien (Membranfolie 202 und Verbindungsfolie 203) und den auftretenden Parametern wie Druck und Temperatur im Spritzgießprozess kann es notwendig sein, eine oder beide Folien vor diesen physikalischen Einflüssen zusätzlich zu schützen, beispielsweise durch Kühlungsmassnahmen oder die spezielle Formung des Spritzgußwerkzeugs, die, wie eben beschrieben, Folienbereiche abdecken kann.

Wie anhand der Figuren zu erkennen ist, dient die mit der Membranfolie 202 verklebte Verbindungsfolie 203 in erster Linie der Verbindung zum Spritzgussteil 207. Gleichzeitig kann sie jedoch zusätzliche Kennzeichnungseigenschaften haben, d.h. als Etikettenfolie dienen, die beispielsweise mit Zeichen und/oder Symbolen bedruckt ist und ggf. weitere integrierte Folienelemente wie Sicherheitselemente oder ähnliches aufweist. In der Ausführungsform mit einem Druckausgleichs-Element-Aufbau gemäß Figur 1c sind die Funktionalitäten des Verbindens und des Kennzeichnens klar verteilt auf die Verbindungsfolie unten und die oberhalb der Membran liegenden Deckfolie. Statt einer einzelnen Folienlage können gemäß der Erfindung auch Folienverbünde verwendet werden, speziell, um nach außen hin Folien zu verwenden, die keine ausreichende Verbindung mit dem jeweiligen Spritzgussmaterial eingehen würden. In diesem Fall dient die unterste Folienschicht als Verbindungsbereich, der mit dem Spritzgussmaterial verschmolzen wird. Auch entsprechende Haftvermittler wie z.B. Druckfarben können diese Verbindungs- und Verschmelzungsfunktion bewirken.

Die besonders bevorzugte Ausführungsform dieser Erfindung ist der in Figur 2 gezeichnete Aufbau, bei dem die Verbindungsfolie 203 oberhalb der Membranfolie 202 liegt, so dass sich die Membranfolie 202 im Innenbereich des Spritzgussteils. 207 befindet. Hierfür spricht vor allem, dass das Spritzgussteil 207 eine plane Oberfläche erhält und die Membranfolie 202 nicht von außen abgezogen oder abgerissen werden kann. Es kann jedoch, speziell bei komplizierten Spritzgussteilen, auch vorteilhaft sein, die Membran außerhalb des Spritzgussteils 207 vorzuhalten.

## Patentansprüche

1. Belüftungsanordnung für ein Bauteil, das zumindest teilweise aus Kunststoff besteht, aufweisend eine Membranfolie (102a-c, 202), **dadurch gekennzeichnet, dass** die Membranfolie mit einer Verbindungsfolie (103a-c, 203)verbunden ist, die mit einer Spritzgussmasse mindestens teilweise verschmolzen ist.

2. Belüftungsanordnung gemäß Anspruch 1, **dadurch gekennzeichnet, dass** die Verbindungsfolie (103a-c, 203) auf der dem Verschmelzungsbereich mit der Spritzgussmasse entgegengesetzten Oberfläche Kennzeichnungselemente aufweist.

3. Belüftungsanordnung gemäß Anspruch 2, **dadurch gekennzeichnet, dass** die Kennzeichnungselemente mindestens aus einer Bedruckung bestehen.

4. Belüftungsanordnung gemäß einem der vorhergehenden Ansprüche, **dadurch gekennzeichnet, dass** die Verbindungsfolie (103a-c, 203) ein Folienverbund ist.

5. Belüftungsanordnung gemäß einem der vorhergehenden Ansprüche, **dadurch gekennzeichnet, dass** die Verbindungsfolie (103a-c, 203) einen Haftvermittler zur Herstellung einer Verbindung zwischen Verbindungsfolie und Spritzgussmasse aufweist.

6. Belüftungsanordnung gemäß einem der vorhergehenden Ansprüche, **dadurch gekennzeichnet, dass** die Membranfolie (102a-c, 202) mittels einer Klebstoffschicht (104a-c) mit der Verbindungsfolie (103a-c, 203) verbunden ist.

7. Belüftungsanordnung gemäß einem der Ansprüche 1-5, **dadurch gekennzeichnet, dass** die Membranfolie (102a-c; 202) durch Verschweissen mit der Verbindungsfolie (103a-c, 203) verbunden ist.

8. Belüftungsanordnung gemäß einem der vorhergehenden Ansprüche, **dadurch gekennzeichnet, dass** die Membranfolie (102a-c, 202) auf der selben Oberflächenseite der Verbindungsfolie (103a-c, 203) angeordnet ist, die die Verschmelzung der Verbindungsfolie mit der Spritzgussmasse aufweist.

9. Belüftungsanordnung gemäß einem der Ansprüche 1-7, **dadurch gekennzeichnet, dass** die Membranfolie (102a-c, 202) auf der anderen Oberflächenseite der Verbindungsfolie (103a-c, 203) angeordnet ist, als die Oberflächenseite, die die Verschmelzung der Verbindungsfolie mit der Spritzgussmasse aufweist.

10. Belüftungsanordnung gemäß einem der vorhergehenden Ansprüche, **dadurch gekennzeichnet, dass** die Verbindungsfolie (103a-c, 203) eine Öffnung in dem Bereich aufweist, in dem die Membranfolie (102a-c, 202) unter- oder oberseitig liegt.

11. Druckausgleichs-Element-Aufbau für ein Bauteil, welches Bauteil zumindest teilweise aus Kunststoff besteht, aufweisend eine Membranfolie (102a-c, 202), **dadurch gekennzeichnet, dass** die Membranfolie mit einer Verbindungsfolie (103a-c, 203) verbunden ist, die mit einer Spritzgussmasse mindestens teilweise verschmelzbar ist.

12. Druckausgleichs-Element-Aufbau gemäß Anspruch 11, **dadurch gekennzeichnet, dass** die Verbindungsfolie (103a-c, 203) auf der dem Verschmelzungsbereich mit der Spritzgussmasse entgegengesetzten Oberfläche Kennzeichnungselemente aufweist.

13. Druckausgleichs-Element-Aufbau gemäß Anspruch 12, **dadurch gekennzeichnet, dass** die Kennzeichnungselemente mindestens aus einer Bedruckung bestehen.

14. Druckausgleichs-Element-Aufbau gemäß einem der Ansprüche 11-13, **dadurch gekennzeichnet, dass** die Verbindungsfolie (103a-c, 203) ein Folienverbund ist.

15. Druckausgleichs-Element-Aufbau gemäß einem der Ansprüche 11-14, **dadurch gekennzeichnet, dass** die Verbindungsfolie (103a-c, 203) einen Haftvermittler zur Herstellung einer Verbindung zwischen Verbindungsfolie und Spritzgussmasse aufweist.

16. Druckausgleichs-Element-Aufbau gemäß einem der Ansprüche 11-15, **dadurch gekennzeichnet, dass** die Membranfolie (102a-c, 202) mittels einer Klebstoffschicht (1 04a-c) mit der Verbindungsfolie (103a-c, 203) verbunden ist.

17. Druckausgleichs-Element-Aufbau gemäß einem der Ansprüche 11-15, **dadurch gekennzeichnet, dass** die Membranfolie (102a-c, 202) durch Verschweissen mit der Verbindungsfolie (103a-c, 203) verbunden ist.

18. Druckausgleichs-Element-Aufbau gemäß einem der Ansprüche 11-17, **dadurch gekennzeichnet, dass** die Membranfolie (102a-c, 202) auf der selben Oberflächenseite der Verbindungsfolie (103a-c, 203) angeordnet ist, an der die Verbindungsfolie mit der Spritzgussmasse verschmelzbar ist.

19. Druckausgleichs-Element-Aufbau gemäß einem der Ansprüche 11-17, **dadurch gekennzeichnet, dass** die Membranfolie (102a-c, 202) auf der anderen Oberflächenseite der Verbindungsfolie (103a-c, 203) angeordnet ist, als die Oberflächenseite, an der die Verbindungsfolie mit der Spritzgussmasse verschmelzbar ist.

20. Druckausgleichs-Element-Aufbau gemäß einem der Ansprüche 11-19, **dadurch gekennzeichnet, dass** die Verbindungsfolie (103a-c, 203) eine Öffnung (1 09a-c, 209) in dem Bereich aufweist, in dem die Membranfolie (102a-c, 202) unter- oder oberseitig liegt.

21. Verfahren zur Herstellung einer Belüftungsanordnung für ein Bauteil, das zumindest teilweise aus Kunststoff besteht, **gekennzeichnet durch** folgende Schritte in der angegebenen Reihenfolge:
- Bereitstellung einer Membranfolie (102a-c, 202), die mit einer Verbindungsfolie (103a-c, 203) verbunden ist,
- Einlegen dieses Folienverbunds in einer Spritzgießform und
- Hinterspritzen des Folienverbunds mit einer Spritzgussmasse.

22. Verfahren gemäß Anspruch 21, **dadurch gekennzeichnet, dass** die Hinterspritzung in einem Bereich der entgegengesetzten Seite Oberfläche der Verbindungsfolie (103a-c, 203) erfolgt, als eine zweite Oberfläche, welche Kennzeichnungselemente aufweist.

23. Verfahren gemäß einem der Ansprüche 21 oder 22, **dadurch gekennzeichnet, dass** zuvor auf die Verbindungsfolie (103a-c, 203) ein Haftvermittler zur Herstellung einer Verbindung zwischen der Verbindungsfolie und der Spritzgussmasse aufgebracht wird.

24. Verfahren gemäß einem der Ansprüche 21-23, **dadurch gekennzeichnet, dass** die Membranfolie (102a-c, 202) zuvor durch Verschweißen oder Verkleben mit der Verbindungsfolie (103a-c, 203) verbunden wird.

25. Verfahren gemäß einem der Ansprüche 21-24, **dadurch gekennzeichnet, dass** die Membranfolie (102a-c, 202) im Spritzgussteil so angeordnet wird, dass sie auf der selben Oberflächenseite liegt, an der die Verschmelzung der Verbindungsfolie (1 03a-c, 203) mit der Spritzgussmasse erfolgt.

26. Verfahren gemäß Anspruch 25, **dadurch gekennzeichnet, dass** die Spritzgießform so geformt wird, dass sie zumindest teilweise die Membranfolie (102a-c, 202) auf der Seite abdeckt, von der die Spritzgussmasse zugeführt wird.

27. Verfahren gemäß Anspruch 26, **dadurch gekennzeichnet, dass** die Spritzgießform so geformt wird, dass sie zumindest den Bereich der Membranfolie (102a-c, 202) abdeckt, in dem in der Verbindungsfolie (103a-c, 203) eine Öffnung liegt.

28. Verfahren gemäß einem der Ansprüche 21-27, **dadurch gekennzeichnet, dass** während des Hinterspritz-Vorgangs mindestens eine der beiden Folienschichten (Membranfolie (102a-c, 202) und / oder Verbindungsfolie (103a-c, 203)) durch zusätzliche Vorrichtungen und / oder Verfahrensschritte vor zu hoher Beanspruchung durch Hitze und / oder Druck geschützt wird.
